(19) **Europäisches Patentamt**
**European Patent Office**
**Office européen des brevets**

(11) **EP 4 757 184 A1**

(12) **EUROPEAN PATENT APPLICATION**

(43) Date of publication:
**10.06.2026 Bulletin 2026/24**

(21) Application number: **25220545.5**

(22) Date of filing: **03.12.2025**

(51) International Patent Classification (IPC):
**H03L 7/081** (2006.01)    **G06F 1/04** (2006.01)

(52) Cooperative Patent Classification (CPC):
**H03L 7/0812; G06F 1/04**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **04.12.2024 US 202418967946**

(71) Applicant: **Avago Technologies International
Sales
Pte. Limited
Singapore 768923 (SG)**

(72) Inventors:
• **Kong, Derui**
  **Irvine, 92620 (US)**
• **Zhang, Wei**
  **Irvine, 92620 (US)**
• **Cui, Delong**
  **Tustin, 92782 (US)**
• **Wang, Jingguang**
  **Laguna Niguel, 92677 (US)**
• **Cao, Jun**
  **Irvine, 92620 (US)**

(74) Representative: **Dilg, Haeusler, Schindelmann
Patentanwaltsgesellschaft mbH
Leonrodstraße 58
80636 München (DE)**

(54) **SYSTEMS AND METHODS FOR CLOCK CALIBRATION IN COMMUNICATION SYSTEMS**

(57) The subject technology is directed to clock calibration systems and methods. In an embodiment, the subject technology provides an apparatus for clock calibration to minimize timing discrepancies between even and odd clock edges. The apparatus includes a first data path configured to generate a first signal, the first signal comprising a first edge and a second edge associated with even and odd clock cycles, respectively. A calibration circuit is coupled to the first data path and configured to determine a timing difference between the first edge and the second edge to calculate even-odd jitter (EOJ). This configuration enables precise calibration to reduce EOJ and ensure accurate synchronization of clock signals in high-speed communication systems.

Figure 2

**Description**

FIELD OF INVENTION

The subject technology is directed to communication systems and methods.

BACKGROUND OF THE INVENTION

Wireline communication is the backbone of Internet infrastructure, connecting homes, businesses, and data centers with high-speed Internet services. Transceivers are components in network communication, converting the electrical signals used within a computer into a form that can be transmitted over a network cable and vice versa. The demand for higher data rates is driven by the ever-increasing need for bandwidth due to video streaming, cloud computing, and other data-intensive applications. The communication channel is divided into multiple lanes, each capable of carrying a separate stream of data.

Emerging Institute of Electrical and Electronics Engineers (IEEE) standards in wireline communication require transceivers to operate at 224 Gbps and beyond per lane. Because the unit interval (UI) period of the data symbol in 224 Gbps PAM4 transceiver is 8.9 ps, such a small UI period places strict requirements on the quality of clocks. For instance, IEEE 802.3 standard specifies strict transceiver specifications, such as even-odd jitter (EOJ) and deterministic jitter (DJ) that are difficult to pass without calibration.

EOJ refers to timing discrepancies between rising edges of even and odd clock signals. These discrepancies may arise from mismatches in clock generation or distribution circuits, including factors like skew, duty-cycle distortion, and other non-idealities. EOJ directly impacts the overall timing of data transmission, leading to reduced signal quality and an increased risk of errors, particularly at high data rates.

Various approaches for mitigating EOJ in high-speed communication systems have been explored, but they have proven to be insufficient. It is important to recognize the need for new and improved clock calibration systems and methods.

BRIEF DESCRIPTION OF THE DRAWINGS

Figure 1 is a timing diagram illustrating a transmitter (TX) output data stream in a serial-link transmitter system according to embodiments of the subject technology.

Figure 2 is a simplified diagram illustrating a clock calibration system according to embodiments of the subject technology.

Figure 3 is a timing diagram illustrating a transmitter output data stream in a serial-link transmitter system according to embodiments of the subject technology.

Figure 4 is a timing diagram illustrating a reference clock signal used for clock calibration according to embodiments of the subject technology.

Figure 5 is a schematic diagram illustrating a method for clock calibration according to embodiments of the subject technology.

Figure 6 is a simplified diagram illustrating a clock calibration system according to embodiments of the subject technology.

Figure 7 is a timing diagram illustrating the generation of a clock signal by a clock generator according to embodiments of the subject technology.

Figure 8 is a timing diagram illustrating the operation of a phase detector and the generation of gated clock signals based on control signals according to embodiments of the subject technology.

Figure 9 is a simplified diagram of a delay tuner circuit with $K \times N$ fine step adjustments according to embodiments of the subject technology.

Figure 10 is a simplified diagram of a clock tuning circuit according to embodiments of the subject technology.

DETAILED DESCRIPTION OF THE INVENTION

The subject technology is directed to clock calibration systems and methods. In an embodiment, the subject technology provides an apparatus for clock calibration to minimize timing discrepancies between even and odd clock edges. The apparatus includes a first data path configured to generate a first signal, the first signal comprising a first edge and a second edge associated with even and odd clock cycles, respectively. A calibration circuit is coupled to the first data path and configured to determine a timing difference between the first edge and the second edge to calculate even-odd jitter (EOJ). This configuration enables precise calibration to reduce EOJ and ensure accurate synchronization of clock signals in high-speed communication systems.

As previously noted, improved systems and methods for clock calibration are desired. More specifically, there is a growing need to address EOJ in high-speed communication systems, where precise timing alignment between even and odd clock edges is beneficial for ensuring reliable data transmission at high data rates.

Some approaches for EOJ calibration may involve independent delay measurements for even and odd clock edges. These sequential measurements are prone to inaccuracies caused by low-frequency noise (e.g., 1/f noise), which introduces variability in delay calculations over time. Furthermore, these methods often require repetitive measurements and averaging to suppress noise, leading to lengthy calibration processes that are unsuitable for real-time environments.

In various embodiments, the subject technology provides an apparatus for clock calibration that addresses these challenges by introducing a calibration circuit designed to determine and correct timing differences between even and odd clock edges. The calibration circuit includes a clock generator that provides a reference clock signal with alternating even and odd edges. A delay tuner measures the timing differences between the edges of the data signal and the reference clock signal, and a phase detector determines the phase difference based on the measured delays. By isolating and measuring specific edges, the apparatus ensures precise EOJ calculation and correction while reducing the impact of low-frequency noise, significantly decreasing the time required for calibration.

It is to be appreciated that embodiments of the subject technology can be beneficial for high-speed serial-link transceivers and other communication systems requiring precise clock synchronization. By providing accurate calibration with reduced noise sensitivity and computational overhead, the subject technology enables compliance with modern standards and improves overall system performance. Moreover, its scalability makes it well-suited for next-generation communication systems operating at ultra-high data rates.

The following description is presented to enable one of ordinary skill in the art to make and use the invention and to incorporate it in the context of particular applications. Various modifications, as well as a variety of uses in different applications, will be readily apparent to those skilled in the art, and the general principles defined herein may be applied to a wide range of embodiments. Thus, the subject technology is not intended to be limited to the embodiments presented but is to be accorded the widest scope consistent with the principles and novel features disclosed herein.

In the following detailed description, numerous specific details are set forth in order to provide a more thorough understanding of the subject technology. However, it will be apparent to one skilled in the art that the subject technology may be practiced without necessarily being limited to these specific details. In other instances, well-known structures and devices are shown in block diagram form, rather than in detail, in order to avoid obscuring the subject technology.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of' in the Claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of' preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

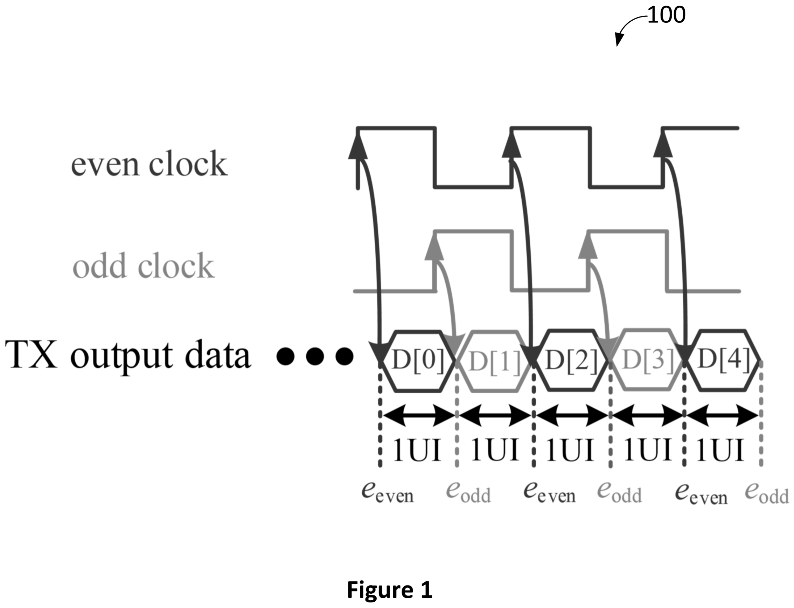

Figure 1 is a timing diagram illustrating a transmitter (TX) output data stream 100 in a serial-link transmitter system according to embodiments of the subject technology. This diagram is merely an example, which should not unduly limit the scope of the claims. One of ordinary skill in the art would recognize many variations, alternatives, and modifications.

As shown in Figure 1, the TX output data stream 100 may include sequential data symbols, including D[0], D[1], D[2], D[3], and D[4], which are spaced by a fixed interval known as the unit interval (UI). For example, the term "unit interval" may refer to the time duration allocated for a single data symbol in a digital data stream. For example, in a 224 Gbps PAM4 transceiver, the UI is approximately 8.9 ps.

Each data symbol transition is triggered alternately by an even clock or an odd clock, forming a staggered pattern of timing edges. For instance, the term "even clock" may refer to a clock signal that triggers transitions associated with even-indexed data symbols. Conversely, the term "odd clock" may refer to a clock signal that triggers transitions associated with odd-indexed data symbols. As an example, the even clock may generate rising edges at times corresponding to 0 UI, 2 UI, 4 UI, etc., and the odd clock may generate rising edges at times corresponding to 1 UI, 3 UI, 5 UI, etc. These clock signals may operate at the same frequency but are offset by 1 UI to enable alternating transitions in the data stream.

In some embodiments, data transitions associated with even-indexed symbols (e.g., D[0], D[2], and D[4]) are aligned with the rising edges of the even clock, denoted as $e_{even}$. Similarly, data transitions for odd-indexed symbols (e.g., D[1] and D[3]) align with the rising edges of the odd clock, denoted as $e_{odd}$. The even and odd clocks ideally exhibit perfect synchronization, where the timing of the even and odd edges ensures that data symbols are spaced by exactly 1 UI. Under ideal conditions, $e_{even}$ and $e_{odd}$ would align such that the jitter between the edges is minimized, resulting in uniform spacing between successive data symbols. However, in real-world systems, clock imperfections-such as phase noise, in-phase and quadrature (IQ) mismatch, or duty cycle distortion (DCD)-introduce timing discrepancies between the even and odd edges. These discrepancies result in EOJ, which is defined as the difference in timing between the even and odd clock edges, expressed as:

$$e_{EOJ} = e_{even} - e_{odd}$$

In the presence of EOJ, the uniform spacing between data symbols is disrupted, potentially leading to errors in signal interpretation and degraded system performance. For example, if the EOJ exceeds a certain threshold, it can cause overlapping or misaligned data symbols, compromising the reliability of high-speed communication systems.

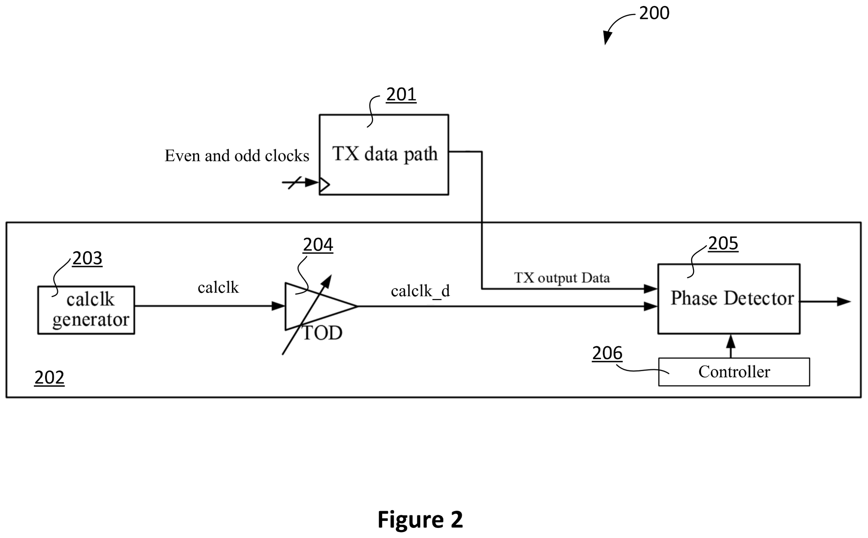

Figure 2 is a simplified diagram illustrating a clock calibration system 200 according to embodiments of the subject technology. This diagram is merely an example, which should not unduly limit the scope of the claims. One of ordinary skill in the art would recognize many variations, alternatives, and modifications. In various implementations, system 200 may be used in high-speed transceivers, wireline communication systems, and serializers/deserializers (SerDes) operating at high data rates (e.g., 224 Gbps or higher). For example, system 200 may be used to mitigate EOJ by measuring and calibrating timing differences between even and odd clock edges.

In some embodiments, system 200 includes data path 201. For example, the term "data path" may refer to a logical or physical path within a system through which data is processed, transmitted, or received. For example, a data path may include components such as clocking circuits, buffers, serializers, and other logic elements that process and transfer data from one stage to another. In some examples, data path 201 may serve as a transmitter data path, which generates an output signal for transmission across a communication channel. The output signal, similar to the TX output data stream 100 shown in Figure 1, may include sequential data symbols that are spaced at fixed intervals. Each transition in the output signal may be triggered alternately by an even clock and an odd clock.

As an example, data path 201 may generate a first signal, which comprises a first edge and a second edge. For example, the term "edge" may refer to the transition point in a waveform where the signal changes from one state to another, such as from a low voltage to a high voltage (e.g., a rising edge) or from a high voltage to a low voltage (e.g., a falling edge). In some cases, the first and second edges may include rising edges triggered by clock signals, such as an even clock signal and an odd clock signal. These alternating clock signals ensure uniform spacing of data symbols under ideal conditions. However, in real-world systems, imperfections in clock signals-such as phase noise, skew, IQ mismatch, or DCD-can introduce EOJ, potentially disrupting the uniform spacing of data in the transmitted output signal.

To address EOJ and improve clock synchronization, system 200 may further include calibration circuit 202, which may be coupled to data path 201. For instance, the term "calibration circuit" may refer to a set of hardware and/or software components designed to analyze and adjust timing, phase, or other signal characteristics of clock signals or data streams. In some embodiments, calibration circuit 202 is configured to determine and correct timing differences between the even and odd edges in the output signal generated by data path 201. For instance, calibration circuit 202 is configured to determine a timing difference between the first edge and the second edge. The term "timing difference" may refer to a discrepancy in timing between two events, such as signal transitions or clock edges. For example, timing differences may include variations caused by skew, phase noise, DCD, EOJ, and/or the like.

In some implementations, calibration circuit 202 includes clock generator 203. For example, the term "clock generator" may refer to an electronic circuit configured to produce a periodic clock signal for synchronizing or timing operations in a system. Examples of clock generators may include, without limitation, crystal oscillators, phase-locked loops (PLLs), delay-locked loops (DLLs), digitally controlled oscillators (DCOs), and/or the like. Depending on the implementation, a clock generator may produce clock signals that drive data transfer operations, synchronize multiple system components, or serve as a reference for timing measurements.

In various examples, clock generator 203 is configured to generate a reference clock signal, denoted as "calclk." For example, the term "reference clock signal" may refer to may refer to a periodic timing signal used as a baseline for synchronizing or measuring other signals within a system. The reference clock signal may serve as a timing reference for measuring and correcting timing discrepancies (e.g., EOJ) in the TX output data stream. In some implementations, the calclk signal exhibits periodicity and is designed to share similar timing characteristics with the TX output signal. For instance, the calclk signal includes rising edges that is close to the expected even and odd clock timing intervals, facilitating direct comparison with the TX output data stream. In some examples, the calclk signal includes a third edge and a fourth edge, where the third edge corresponds to an even timing interval and the fourth edge corresponds to an odd timing interval. The reference clock signal provides a stable reference for calibration circuit 202 to measure timing differences between the even and odd edges in the TX output signal.

According to some embodiments, calibration circuit 202 includes delay tuner 204, which may be coupled to clock generator 203 and/or data path 201. For example, the term "delay tuner" may refer to an electronic component that introduces a controllable delay to a signal. Delay tuners may be implemented using digitally controlled delay lines, PLLs, or buffer chains with tunable delay elements. Examples of delay tuners may include, without limitation, tunable on-chip delay (TOD) elements, DLLs, and/or the like.

In various implementations, delay tuner 204 may be configured to adjust the timing of the reference clock signal generated by clock generator 203, enabling alignment with the TX output data signal produced by data path 201. For instance, delay tuner 204 applies programmable delays to create a delayed reference clock signal, denoted as "calclk_d," which is used to measure the timing relationships between the TX output signal and the reference clock signal. In some examples, delay tuner 204 may include a delay line, which consists of one or more stages, each capable of introducing incremental delays. The delay value for the delay line may be controlled by a digital tuning code, allowing fine-grained adjustment of the delay applied to the calclk signal. For example, the tuning code may incrementally adjust the delay in steps corresponding to fractions of a unit interval, enabling precise control over the alignment of the calclk_d signal with the TX output signal.

In some embodiments, the delayed reference clock signal generated by delay tuner 204 may be used to measure delays between the TX output signal and the reference clock signal. For example, delay tuner 204 is configured to determine a first delay between the first edge of the TX output signal and the third edge of the reference clock signal. For example, the term "delay" may refer to a timing difference between two related events (e.g., rising or falling edges). Similarly, a second delay can be measured between the second edge of the TX output signal and the fourth edge of the reference clock signal. By iteratively adjusting the delay and re-evaluating the phase differences between calclk_d and the TX output, delay tuner 204 ensures that calibration circuit 202 can detect and correct EOJ with high precision.

In various implementations, calibration circuit 202 includes phase detector 205, which may be coupled to delay tuner 204 and/or data path 201. For example, the term "phase detector" may refer to an electronic circuit that measures the phase difference between two signals. Examples of phase detectors may include, without limitation, XOR-based detectors, sequential phase detectors, digital sampling phase detectors, and/or the like.

In some embodiments, phase detector 205 may be configured to determine a phase difference between the even and odd edges in the TX output data and the corresponding edges in the delayed reference clock signal. For instance, the term "phase difference" may refer to the temporal offset or discrepancy between the timing of corresponding signal transitions (e.g., rising or falling edges) in two periodic signals. For example, a phase difference can occur when one signal's rising edge either precedes (e.g., leads) or follows (e.g., lags) the rising edge of another signal. In various examples, phase detector 205 receives the TX output signal and the calclk_d signal as inputs and generates an output indicative of the detected phase difference. For instance, phase detector 205 determines whether the rising edges of the TX output signal lead or lag the corresponding edges of the calclk_d signal. In some examples, the output of phase detector 205 includes a one-bit (1b) digital signal, which indicates the phase relationship between the two signals. For instance, a logic 0 output may indicate that the TX output edge is lagging the calclk_d edge (e.g., negative phase difference), and a logic 1 output may indicate that the TX output edge is leading the calclk_d edge (e.g., positive phase difference).

According to some embodiments, calibration circuit 202 further includes controller 206, which may be coupled to phase detector 205 and/or delay tuner 204. Controller 206 works in conjunction with phase detector 205 and delay tuner 204 to perform clock calibration. In some examples, controller 206 is configured to receive the output from phase detector 205 and use this information to generate digital tuning code for adjusting the delay applied by delay tuner 204.

In various implementations, phase detector 205 may adopt an edge selection mechanism, which enables it to alternate between measuring the even and odd clock edges in an interleaved fashion. For example, phase detector 205 may be configured to measure the phase difference between the first edge of the TX output signal and the third edge of the calclk_d signal in one cycle and the phase difference between the second edge of the TX output signal and the fourth edge of the calclk_d signal in the next cycle. In some examples, this edge selection process is managed by controller 206, which is configured to transmit a control signal (e.g., an edge selection signal) to phase detector 205 to select between even edges (e.g., the first edge) and odd edges (e.g., the second edge) for delay measurement. This interleaved measurement process reduces noise sensitivity and ensures accurate detection of EOJ, particularly in the presence of low-frequency noise (e.g., 1/f noise).

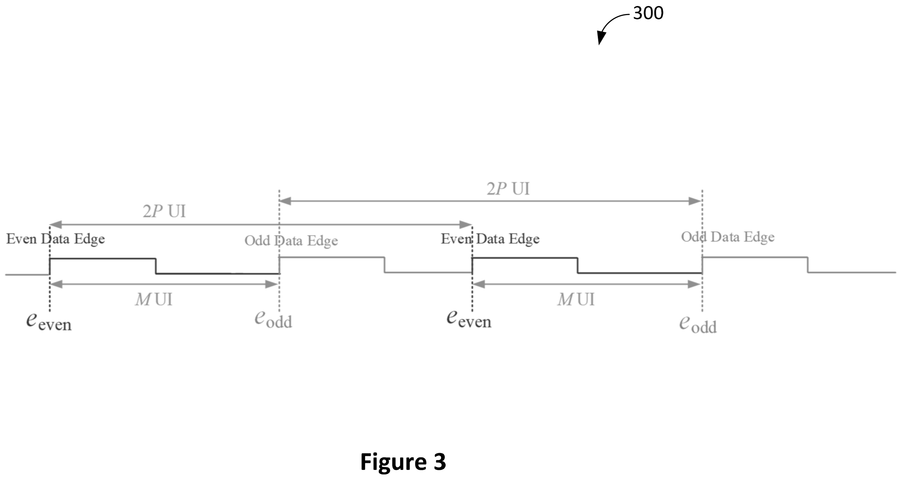

Figure 3 is a timing diagram illustrating a transmitter output data stream 300 in a serial-link transmitter system according to embodiments of the subject technology. This diagram is merely an example, which should not unduly limit the scope of the claims. One of ordinary skill in the art would recognize many variations, alternatives, and modifications.

In various implementations, data stream 300 may be generated by a transmitter data path (e.g., data path 201 of Figure 2). As shown, data stream 300 includes sequential data symbols (e.g., a periodic 2-level data symbol), each spaced at fixed intervals. The transitions between data symbols may be triggered by alternating clock edges from an even clock and an odd clock. For example, even edges (e.g., $e_{even}$) are associated with rising edges of the even clock, and odd edges (e.g., $e_{odd}$) are associated with rising edges of the odd clock. In some examples, the even rising edges in the data stream are spaced apart by $2P$ UI, and the odd rising edges are also spaced apart by $2P$ UI, where $P$ is any integer. The spacing between an even rising edge and the nearest odd rising edge is approximately $M$ UI, where $M$ is any odd integer greater than $P$. The alternating pattern of even and odd edges defines the timing structure of data stream 300.

In various embodiments, deviations from ideal conditions may arise due to imperfections in the clock signals, such as phase noise, skew, IQ mismatch, DCD, and/or the like. These imperfections may result in EOJ, which represents variations in the spacing between data edges, disrupting the uniform timing of the data symbols and potentially impairing the performance of the transmitter system. As a result, EOJ calibration is often necessary to ensure proper alignment of the data stream. The calibration may be performed by a calibration circuit (e.g., calibration circuit 202 of Figure 2), which is configured to measure and correct EOJ to maintain uniform data spacing and reliable transmitter performance.

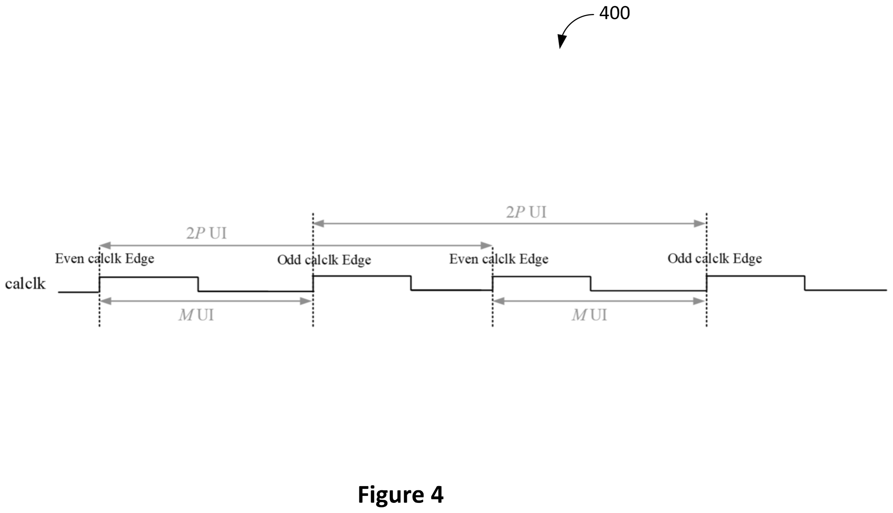

Figure 4 is a timing diagram illustrating a reference clock signal 400 used for clock calibration according to embodiments of the subject technology. This diagram is merely an example, which should not unduly limit the scope of the claims. One of ordinary skill in the art would recognize many variations, alternatives, and modifications.

In various implementations, reference clock signal 400 is generated by a clock generator (e.g., clock generator 203 of Figure 2) and is used as a baseline for measuring and correcting timing discrepancies (e.g., EOJ) in a transmitter output data stream (e.g., data stream 300 of Figure 3). For example, a calibration circuit (e.g., calibration circuit 202 of Figure 2) may use the even and odd rising edges of reference clock signal 400 to measure delays relative to the corresponding even and odd edges of the TX output signal.

In some examples, reference clock signal 400 exhibits periodicity and shares similar timing characteristics with the TX output data stream, such as alternating even and odd edges that define its timing structure. For instance, the even rising edges in signal 400 are spaced apart by $2P$ UI, and the odd rising edges are also spaced apart by $2P$ UI, where $P$ is any integer. The spacing between an even rising edge and the nearest odd rising edge is approximately $M$ UI, where $M$ is any odd integer greater than $P$.

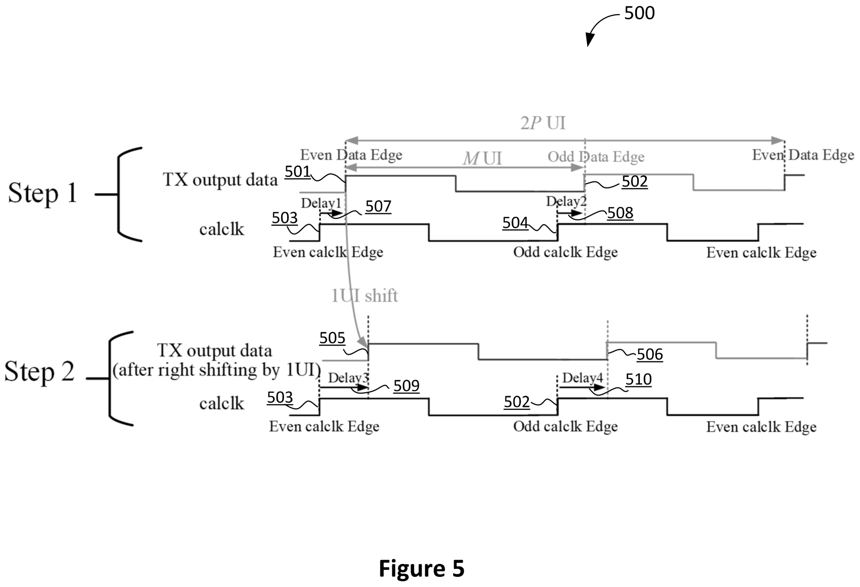

Figure 5 is a schematic diagram illustrating a method 500 for clock calibration according to embodiments of the subject technology. This diagram is merely an example, which should not unduly limit the scope of the claims. One of ordinary skill in the art would recognize many variations, alternatives, and modifications. In various embodiments, method 500 may be implemented by a calibration circuit (e.g., calibration circuit 202 of Figure 2) to mitigate EOJ in a transmitter output signal. For instance, method 500 may involve measuring and aligning the timing relationship between a transmitter output signal (e.g., TX output data) and a reference clock signal (e.g., calclk).

As shown, method 500 may include two steps. Each step may be implemented using specific elements of the calibration circuit. In Step 1, the calibration circuit measures delays between the edges of the TX output signal and the edges of the calclk signal. For example, an even rising edge of calclk signal (e.g., third edge 503) is compared to the nearest rising edge of the TX output data (e.g., first edge 501) to determine first delay 507 (e.g., Delay1). Similarly, an odd rising edge of calclk signal (e.g., fourth edge 504) is compared to the nearest rising edge of the TX output data (e.g., second edge 502) to determine second delay 508 (e.g., Delay2). Depending on the implementation, this measurement may be performed using a delay tuner (e.g., delay tuner 204 of Figure 2) and/or a phase detector (e.g., phase detector 205 of Figure 2).

In Step 2, the TX output data is shifted. For instance, the TX output data may be shifted to the right by a predetermined interval, effectively altering the alignment of its edges with respect to the reference clock signal. For example, the calibration circuit is configured to generate a shifted signal by shifting the TX output signal by a predetermined interval of odd integer number of UI (e.g., 1 UI) relative to the calclk signal. Depending on the implementation, the interval may be calculated, fed via feedback, or otherwise determined based on system requirements. The shifted signal may include fifth edge 505 associated with first edge 501 and sixth edge 506 associated with second edge 502. The even rising edge of calclk signal (e.g., third edge 503) is then compared to the nearest rising edge of the TX output data (e.g., fifth edge 505) to determine third delay 509 (e.g., Delay3). Similarly, the odd rising edge of calclk signal (e.g., fourth edge 504) is then compared to the nearest rising edge of the TX output data (e.g., sixth edge 506) to determine fourth delay 510 (e.g., Delay4). In some embodiments, the timing difference between first edge 501 and second edge 502 is associated with first delay 507, second delay 508, third delay 509, and fourth delay 510.

Based on the delay measurements from both steps, the EOJ is calculated as follows:

$$EOJ = ((Delay1 - Delay2) - (Delay3 - Delay4))/2$$

The inclusion of measurements from both the original and shifted TX output data ensures that the calibration process is robust to imperfections in the calclk signal and the phase detector. For example, if the spacing between even and odd rising edges of the calclk signal exhibits additional skew or phase offset, the impact is canceled by the subtraction operation in the EOJ equation, thereby preserving the accuracy of the calibration.

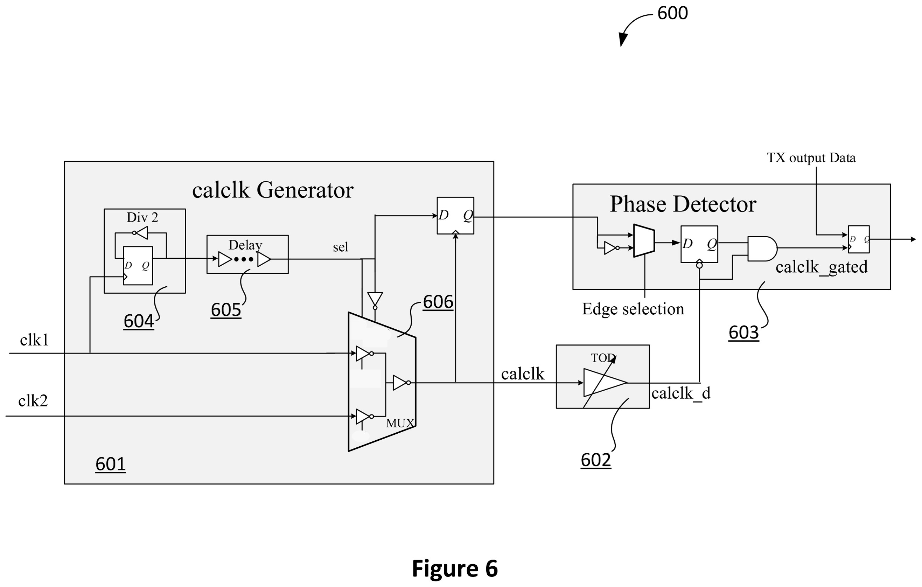

Figure 6 is a simplified diagram illustrating a clock calibration system 600 according to embodiments of the subject technology. This diagram is merely an example, which should not unduly limit the scope of the claims. One of ordinary skill in the art would recognize many variations, alternatives, and modifications.

In various implementations, system 600 may be used in high-speed transceivers, wireline communication systems, and serializers/deserializers (SerDes) operating at high data rates (e.g., 224 Gbps or higher). For example, system 600 may be used to mitigate EOJ by measuring and calibrating timing differences between even and odd clock edges. As shown, system 600 may include clock generator 601, delay tuner 602, and phase detector 603, which collectively work to measure and correct timing discrepancies in high-speed communication systems.

In various implementations, clock generator 601 is configured to produce a reference clock signal (e.g., calclk), which is used as a timing reference for calibration. Clock generator 601 receives two input clock signals (e.g., clk1 and clk2) and selects between the two clock signals using a selection signal (e.g., sel). In some examples, clock generator 601 includes divide-by-2 circuit 604, which may be configured to generate a lower-frequency clock signal from clk1. Timing circuit 605 may be coupled to divide-by-2 circuit 604 and configured to generate the selection signal (e.g., sel). In some cases, clock generator 601 further includes multiplexer (MUX) 606, which is configured to select between clk1 and clk2 based on the selection signal. The generated calclk signal provides a periodic reference for phase comparison and delay measurement in the calibration process.

In some embodiments, delay tuner 602 is coupled to clock generator 601 and is configured to introduce programmable delays to the calclk signal to generate a delayed reference clock signal (e.g., calclk_d). The delay values may be controlled by digital tuning codes, which are dynamically updated to maintain alignment with the edges of the TX output signal. The delayed signal (e.g., calclk_d) generated by delay tuner 602 may be subsequently provided to phase detector 603.

According to various embodiments, phase detector 603 receives the calclk_d signal and the TX output data as inputs and is configured to determine a phase difference between the even and odd edges in the TX output data and the corresponding edges in the delayed reference clock signal. In some examples, phase detector 603 may be controlled by a control signal (e.g., edge selection) to select between even edges and odd edges for delay measurement. For instance, when the edge selection signal is set to 0, phase detector 603 detects the phase difference between the rising edge of calclk_d corresponding to the even clock and the closest rising edge of the TX output signal, measuring delays such as the first delay (e.g., between the first and third edges) and the third delay (e.g., between the third and fifth edges). When the edge selection signal is set to 1, phase detector 603 detects the phase difference between the rising edge of calclk_d corresponding to the odd clock and the closest rising edge of the TX output signal, measuring delays such as the second delay (e.g., between the second and fourth edges) and the fourth delay (e.g., the fourth and sixth edges).

It is to be appreciated that the edge selection mechanism helps mitigate the influence of low-frequency 1/f noise by ensuring that delay measurements for even and odd edges are alternated and collected in close temporal proximity. As previously noted, the EOJ calculation combines these measurements with opposing signs (e.g., EOJ = ((Delay1 - Delay2) - (Delay3 - Delay4)) / 2), any correlated noise affecting both even and odd delays is effectively canceled out. Additionally, the periodic toggling of the edge selection signal minimizes the impact of slowly varying noise, allowing the calibration process to maintain high accuracy and robustness against low-frequency disturbances.

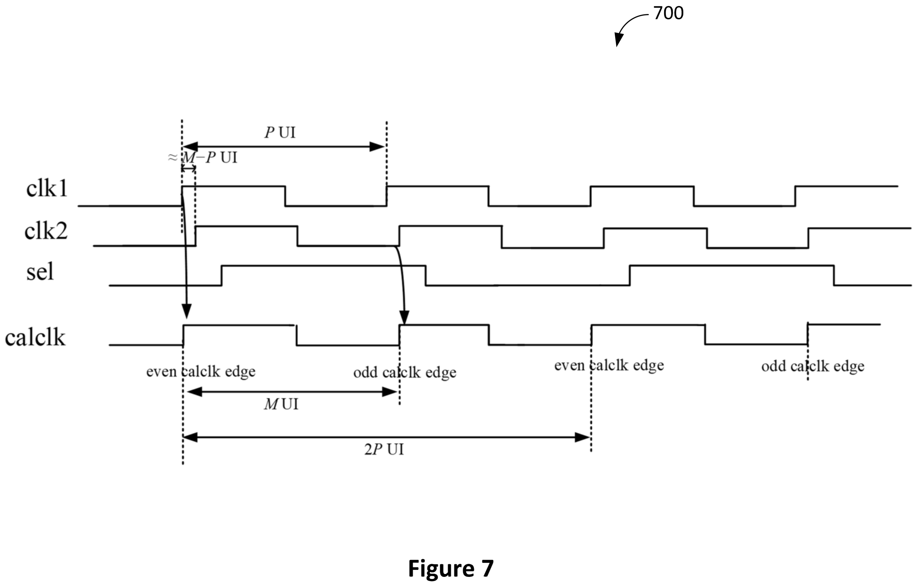

Figure 7 is a timing diagram 700 illustrating the generation of a clock signal (e.g., calclk) by a clock generator (e.g., clock generator 601 of Figure 6) according to embodiments of the subject technology. This diagram is merely an example, which should not unduly limit the scope of the claims. One of ordinary skill in the art would recognize many variations, alternatives, and modifications.

In various implementations, clock generator 601 receives two input clock signals, clk1 and clk2, each having a period of $P$ UI. As shown, clk1 and clk2 may exhibit a relative delay of approximately $M$-$P$ UI, where $M$ is an odd integer greater than $P$. Clock generator 601 is configured to dynamically select between clk1 and clk2 to generate a periodic reference clock signal (e.g., calclk). The selection process is controlled by a timing circuit (e.g., timing circuit 605 of Figure 6) that generates a selection signal (e.g., sel). For instance, when sel is set to a first state (e.g., logic 0), the clock generator selects clk1, resulting in an even calclk edge derived from clk1. Similarly, when sel is set to a second state (e.g., logic 1), clk2 is selected, producing an odd calclk edge derived from clk2. This alternating selection generates a periodic calclk signal with a period of $M$ UI, where the spacing between consecutive even or odd edges is $2P$ UI.

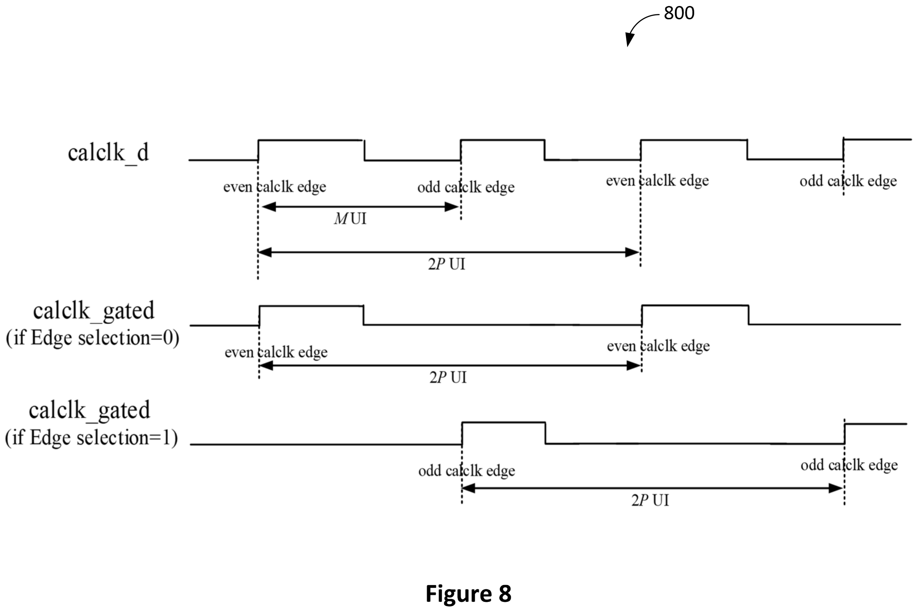

Figure 8 is a timing diagram 800 illustrating the operation of a phase detector (e.g., phase detector 603 of Figure 6) and the generation of gated clock signals (e.g., calclk_gated) based on control signals (e.g., edge selection signal) according to embodiments of the subject technology. This diagram is merely an example, which should not unduly limit the scope of the claims. One of ordinary skill in the art would recognize many variations, alternatives, and modifications.

According to various embodiments, phase detector 603 receives the delayed reference clock signal (e.g., calclk_d) and the TX output data as inputs and is configured to determine a phase difference between the even and odd edges in the TX output data and the corresponding edges in the calclk_d signal. As shown, the calclk_d signal includes a periodic calclk signal with a period of $M$ UI, where the spacing between consecutive even or odd edges is $2P$ UI.

In some examples, phase detector 603 operates under the control of the edge selection signal to selectively gate either the even clock edges or the odd clock edges of calclk_d, resulting in the generation of gated clock signals (e.g., calclk_gated). For example, when the edge selection signal is set to 0, phase detector 603 is configured to gate only the even clock edges of calclk _d. This produces the calclk_gated signal, which aligns with the even clock edges and is used to measure delays associated with the even clock edges of the TX output data. Similarly, when the edge selection signal is set to 1, phase detector 603 gates the odd clock edges of calclk_d to generate a separate instance of calclk_gated, which is aligned with the odd clock edges and is used to measure delays associated with the odd clock edges of the TX output data.

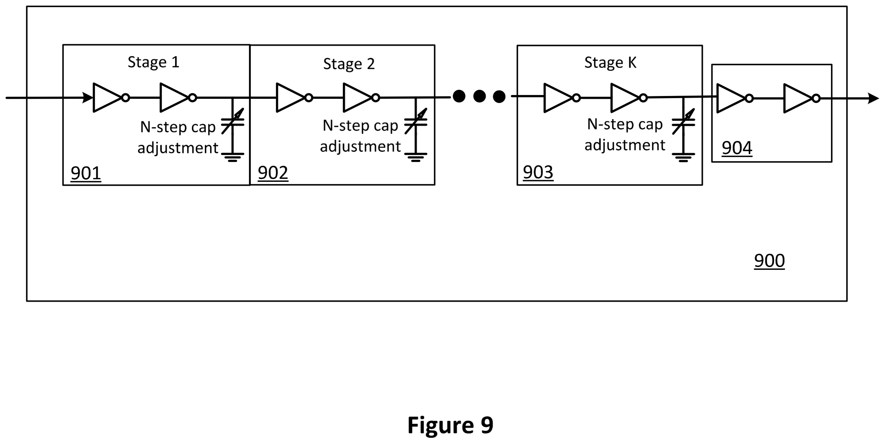

Figure 9 is a simplified diagram of a delay tuner circuit 900 with $K \times N$ fine step adjustments according to embodiments of the subject technology. This diagram is merely an example, which should not unduly limit the scope of the claims. One of ordinary skill in the art would recognize many variations, alternatives, and modifications.

In various implementations, delay tuner circuit 900 may be part of a calibration circuit (e.g., delay tuner 602 of Figure 6) and is designed to introduce programmable delays to a clock signal (e.g., calclk). As shown, delay tuner circuit 900 may include $K$ identical stages (e.g., stages 901, 902, 903, etc.). Each stage may include a two-inverter buffer and an $N$-step tunable capacitor placed after the second inverter of each buffer stage. The $K$-stages delay tuner is followed by a two-inverter buffer 904.

In some embodiments, the tunable capacitor is configured with capacitance values adjustable in $N$ linear steps, enabling fine-grained control over the delay introduced by each stage. The placement of the tunable capacitor at the output end of each buffer stage is to eliminate the step size variation that would otherwise come from the imbalance between the rise and fall delay of the inverters in the buffer stage. In some examples, the tunable capacitors may be controlled using digitally programmable tuning codes, which enable or disable individual unit capacitors within each stage, thereby modifying the effective capacitance and delay. All the $K$ stages delay tuners are combined together to realize total $K \times N$ step adjustment. Depending on the implementation, the $K \times N$ bit may be generated from a $Log_2(K \times N)$-bit binary code using a binary-to-thermometer decoder.

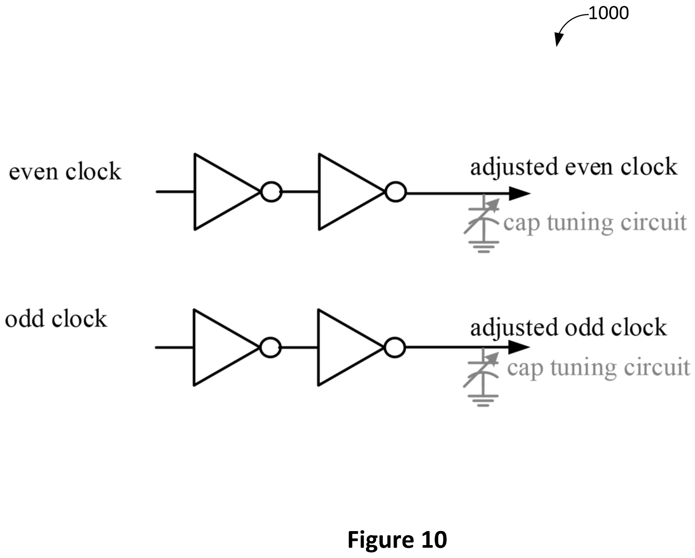

Figure 10 is a simplified diagram of a clock tuning circuit 1000 according to embodiments of the subject technology. This diagram is merely an example, which should not unduly limit the scope of the claims. One of ordinary skill in the art would recognize many variations, alternatives, and modifications.

In various implementations, once the EOJ is determined by a calibration circuit (e.g., calibration circuit 202 of Figure 2), the results may be used to perform error correction to refine the timing alignment between clock edges. For instance, the calibration circuit is configured to generate a calibration signal to adjust at least one of the even clock signal or the odd clock signal based on the timing difference between the even edge (e.g., the first edge) and the odd edge (e.g., the second edge). Depending on the implementation, the correction may be achieved in various ways, such as adjusting the cap loading, the bias current, or the reference voltage in the clock buffer. After the initial correction, additional iterations of EOJ measurement and adjustment can further enhance the calibration accuracy, ensuring optimal performance in high-speed communication systems.

As shown in Figure 10, an example of EOJ correction may involve using cap tuning circuits integrated with the even and odd clock generation circuits. These circuits enable precise adjustments to the delay of the even and odd clock signals, ensuring accurate alignment between the clock edges and the transmitted data edges. For instance, each of the even clock and odd clock generation circuits incorporates a tunable capacitance, which is placed at the output of a buffer stage. By controlling the capacitance through digital tuning codes, the delay of the corresponding clock signal can be incrementally increased or decreased.

As an example, the correction process begins with the tuning codes for both the even and odd clock circuits initialized to zero. The EOJ may be measured using the calibration circuit, which determines the relative phase difference between the even and odd clock edges. If the EOJ value is positive-indicating that the even clock edge leads the odd clock edge-the tuning code for the odd clock circuit is incremented, slightly increasing the delay of the odd clock signal. Conversely, if the EOJ value is negative, meaning the odd clock edge leads the even clock edge, the tuning code for the even clock circuit is adjusted to increase its delay. The tuning process may be digitally controlled, with adjustments applied in small steps to ensure fine-grained corrections. The calibration circuit continuously measures the EOJ after each adjustment and updates the tuning codes until the measured EOJ flips polarity, indicating that the even and odd clocks are aligned.

While the above is a full description of the specific embodiments, various modifications, alternative constructions, and equivalents may be used. Therefore, the above description and illustrations should not be taken as limiting the scope of the subject technology which is defined by the appended claims.

**Claims**

1.   An apparatus for clock calibration, comprising:

   a first data path configured to generate a first signal, the first signal comprising a first edge and a second edge; and
   a calibration circuit coupled to the first data path, the calibration circuit being configured to determine a timing difference between the first edge and the second edge, the calibration circuit comprising:

      a clock generator configured to generate a reference clock signal, the reference clock signal comprising a third edge and a fourth edge;
      a delay tuner coupled to the clock generator and the first data path, the delay tuner being configured to determine a first delay between the first edge and the third edge and a second delay between the second edge and the fourth edge; and
      a phase detector coupled to the delay tuner and configured to determine a phase difference between the first signal and the reference clock signal based at least on the first delay and the second delay.

2.   The apparatus of claim 1, wherein
   the calibration circuit and in particular the delay tuner is further configured to generate a second signal by shifting the first signal relative to the reference clock signal, the second signal comprises a fifth edge associated with the first edge and a sixth edge associated with the second edge.

3.   The apparatus of claim 2, wherein
   the delay tuner is further configured to determine a third delay between the third edge and the fifth edge and a fourth delay between the fourth edge and the sixth edge.

4.   The apparatus of claim 3, wherein
   the timing difference between the first edge and the second edge is associated with the first delay, the second delay, the third delay, and the fourth delay.

5.   The apparatus of claim 2, 3 or 4, wherein
   the calibration circuit is configured to generate the second signal by shifting the first signal by a predetermined interval relative to the reference clock signal.

6.   The apparatus of any one of the preceding claims, wherein

the first edge is associated with an even clock signal and the second edge is associated with an odd clock signal.

7. The apparatus of claim 6, wherein
the calibration circuit is configured to generate a calibration signal to adjust at least one of the even clock signal or the odd clock signal based on the timing difference between the first edge and the second edge.

8. The apparatus of claim 7, wherein
the calibration signal is configured to adjust at least one of a capacitance, a bias current, or a reference voltage in a clock buffer.

9. The apparatus of any one of the preceding claims, wherein
the calibration circuit further comprises a controller coupled to the phase detector, the controller is configured to transmit a control signal to the phase detector to select between the first edge and the second edge for delay measurement.

even clock

odd clock

TX output data  • • •  D[0]  D[1]  D[2]  D[3]  D[4]

1UI  1UI  1UI  1UI  1UI

$e_{even}$  $e_{odd}$  $e_{even}$  $e_{odd}$  $e_{even}$  $e_{odd}$

100

**Figure 1**

EP 4 757 184 A1

**Figure 2**

Figure 3

400

Figure 4

Figure 5

Figure 6

EP 4 757 184 A1

**Figure 7**

EP 4 757 184 A1

**Figure 8**

Figure 9

EP 4 757 184 A1

Figure 10

Europäisches
Patentamt

European
Patent Office

Office européen
des brevets

# EUROPEAN SEARCH REPORT

**Application Number**

EP 25 22 0545

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/241249 A1 (BALAMURUGAN GANESH [US] ET AL) 18 August 2016 (2016-08-18) | 1,6-8 | INV. H03L7/081 |
| A | * paragraph [0001] - paragraph [0076]; figures 1-10 * | 2-5,9 | G06F1/04 |
| X,P | EP 4 618 421 A1 (AVAGO TECH INT SALES PTE LID [SG]) 17 September 2025 (2025-09-17) | 1,6-9 | |
| A,P | * paragraph [0001] - paragraph [0067]; figures 1A-11 * | 2-5 | |
| A | US 2009/177457 A1 (DAI XINGDONG [US]; AGERE SYSTEMS INC [US] ET AL.) 9 July 2009 (2009-07-09) * paragraph [0001] - paragraph [0030]; figures 1-3 * | 1-9 | |
| A | US 9 219 470 B1 (VENDITTI MICHAEL BEN [CA]) 22 December 2015 (2015-12-22) * column 1 - column 21; figures 1-27B * | 1-9 | |
| A | US 2019/215146 A1 (KE YANJING [US] ET AL) 11 July 2019 (2019-07-11) * paragraph [0001] - paragraph [0051]; figures 1-6 * | 1-9 | TECHNICAL FIELDS SEARCHED (IPC)<br><br>H03L<br>G06F |

The present search report has been drawn up for all claims

| Place of search | Date of completion of the search | Examiner |
|---|---|---|
| The Hague | 14 April 2026 | Rafflenbeul, A |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 22 0545

This annex lists the patent family members relating to the patent documents cited in the above-mentioned European search report.
The members are as contained in the European Patent Office EDP file on
The European Patent Office is in no way liable for these particulars which are merely given for the purpose of information.

14-04-2026

| Patent document cited in search report | | | Publication date | Patent family member(s) | | Publication date |
|---|---|---|---|---|---|---|
| US 2016241249 | A1 | | 18-08-2016 | CN 104734697 A | | 24-06-2015 |
| | | | | DE 112013007457 T5 | | 09-06-2016 |
| | | | | EP 3072239 A1 | | 28-09-2016 |
| | | | | US 2016241249 A1 | | 18-08-2016 |
| | | | | WO 2015076789 A1 | | 28-05-2015 |
| EP 4618421 | A1 | | 17-09-2025 | EP 4618421 A1 | | 17-09-2025 |
| | | | | US 2025291381 A1 | | 18-09-2025 |
| | | | | US 20260099169 A1 | | 09-04-2026 |
| US 2009177457 | A1 | | 09-07-2009 | NONE | | |
| US 9219470 | B1 | | 22-12-2015 | NONE | | |
| US 2019215146 | A1 | | 11-07-2019 | NONE | | |

EPO FORM P0459

For more details about this annex : see Official Journal of the European Patent Office, No. 12/82